# EUROPEAN PATENT APPLICATION

(11) **EP 1 696 527 A2**
(43) Date of publication of application: **30.08.2006**
(21) Application number: 06250939.3
(22) Date of filing: 22.02.2006
(51) Int. Cl.: H01S 5/12, H01S 5/125

(54) **Low loss grating for high efficiency wavelength stabilized high power lasers**

(30) Priority: 24.02.2005 US 655781 P
(71) Applicant: JDS Uniphase Inc., San Jose, CA 95131 (US)
(72) Inventor: Peters, Matthew Glenn, Menlo Park, California 94025 (US); Zhao, Hanmin, Fremont, California 94539 (US)
(74) Representative: McKechnie, Neil Henry

(57) **Abstract**

A low optical loss and high efficiency grating is placed within a broad-area high-power laser diode or single spatial mode laser diode to narrow the spectral width and stabilize the emission wavelength. Several embodiments of grating configurations are presented, together with the measured results of a reduction to practice of a particular embodiment.

## Description

### Cross Reference to a Related Application

This applications claims priority of U.S. Provisional Patent Application No. 60/655,781 filed on February 24, 2005, entitled " Low Loss Grating for High Efficiency Wavelength Stabilized High Power Lasers" which is incorporated herein by reference for all purposes.

### Field of the Invention

This invention relates to a broad area high-power semiconductor laser diode, which has a low-loss grating placed within its active region, whereby the spectral width of laser emission is made narrower and the wavelength of the radiation emitted by the diode is stabilized.

### Background of the Invention

High power broad area and single spatial mode semiconductor lasers are used in a variety of applications that require some stability of the wavelength over a range of a few nanometers. Examples include broad area laser pumping of solid-state crystals such as Nd:YAG which requires a pump wavelength of about 808 ±3nm, broad area laser pumping of ytterbium doped fiber amplifiers and lasers which require pump wavelengths of about 970 ±1nm, or single spatial mode laser pumping of erbium doped fiber amplifiers (EDFA) which requires a pump wavelength of about 975 ±0.5nm.

Note that with this type of pump source there is no need for single frequency operation. Multiple longitudinal laser modes within a few nanometer wide envelope is acceptable or in some cases even desirable.

Another problem is that changes in temperature, laser drive current and power or optical feedback can shift the laser diode wavelength out of the specified range.

One common method to control the wavelength is to use a periodic grating, such as in distributed Bragg reflector (DBR) or distributed feedback Bragg (DFB) lasers. However most work on gratings has been to achieve single frequency operation for relatively low power lasers.

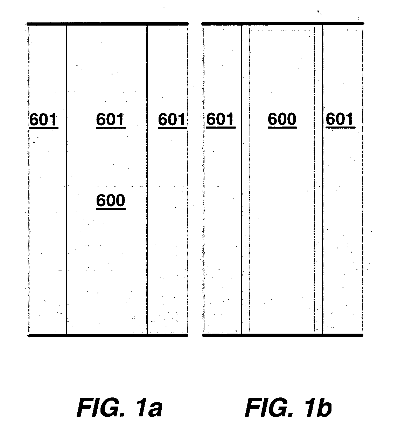

For instance, Kagawa et al. (US Pat 4,984,242) disclose an aluminum gallium arsenide (AlGaAs) semiconductor gain-coupled DFB laser which operates in single longitudinal mode. The lateral grating, which modulates the width of the current injected region, extends over the whole length of the laser, as illustrated in Fig. 1b.

On the other hand, Okuda et al. (US Pat 5,568,505) disclose a similar device in the indium gallium arsenide phosphide (InGaAsP) material system emitting at a wavelength of 1310nm. In order to optimize their laser structure for analog modulation performance, which requires very linear single mode performance characteristics (low 3^{rd} harmonic intermodulation distortion), they implement a grating with a coupling coefficient by cavity length product between 0.4 and 1.0 in value. The grating in some of the embodiments they present can be partial, i.e. occupying only a portion of the cavity length and may incorporate a quarter-wave shifted grating. Their device is optimised to relatively low optical output powers, below about 10mW.

Another example is a wavelength stabilized single mode laser in the aluminum indium gallium arsenide phosphide (AlInGaAsP) material system as disclosed by Fukunaga (U.S. Pat. 5,602,866). They describe a photonic integrated circuit with three sections on a single waveguide incorporating a DBR laser, a modulator and an amplifier. Their approach is to generate a single mode lasing frequency at relatively low power, modulate it with a signal and then optically amplify it for high power output. However, they are silent on some key parameters, which are essential for high power pumping operation, such as, suitable values for front and rear facet reflectivity, cavity length, and product of coupling coefficient - cavity length.

Botez et al. (U.S. Pats. 6,195,381 and 6,363,092) teach a broad-area DFB laser for optical pumping applications. However, since the grating extends for the total length of the lasing cavity, practical limitations exist to keeping the coupling coefficient to adequately low values. As their used cavity length is longer than 1.0 mm, Botez et al. recommend a coupling coefficient - length product of about unity. As is known in the art, DFB can lase in one of two modes, depending on the coupling coefficient value. Avoiding this ambiguity can restrict the coupling coefficient values.

Muroya (US Pat 6,577,660) describes a laser diode based on the InGaAsP material system. This system is known to possess intrinsic electronic mechanisms, which differ fundamentally from those of the AlGaAs system, so they must be optimised in a totally different way to achieve high output optical power. For this reason, Muroya describes a relatively short DFB structure, about 300 micron in length and incorporating a quarter-wave shifted grating which is advantageous for, among other things, reducing the internal peak power density. The technology for fabricating such a grating is rather more complex. The emission wavelengths achievable in this system are also not suitable for the pumping applications which are a major aspect of this disclosure.

Nakamura (US Pat 6,678,302) employs the same material system as Muroya, but focuses on integrating the laser diode with a modulator. However, he does not specify suitable values for the product of coupling coefficient and cavity length.

This invention proposes to use a low loss grating to achieve moderate wavelength stability of a broad-area or single spatial mode laser diode without adversely affecting the laser diode efficiency or maximum optical power. Low loss can be achieved in a variety of methods including putting the grating far from the active region where the mode intensity is small, making the grating layer very thin or making a grating with a small index variation. In addition, a first-order grating is preferably used for lowest optical loss, although second-order gratings could also be applied.

### Summary of the Invention

There are four distinct grating and facet reflectivity configurations that are disclosed: a) a front facet DBR or partial DFB structure with low anti-reflection (AR) coating, b) a rear facet DBR or partial DFB with AR coating, c) a rear facet DBR or partial DFB with high reflectivity (HR) coating and d) a distributed feedback Bragg grating structure everywhere.

Top views of these structures are shown in Figures 1a through 1d. The partial DFB section differs from a DBR in that it is electrically pumped.

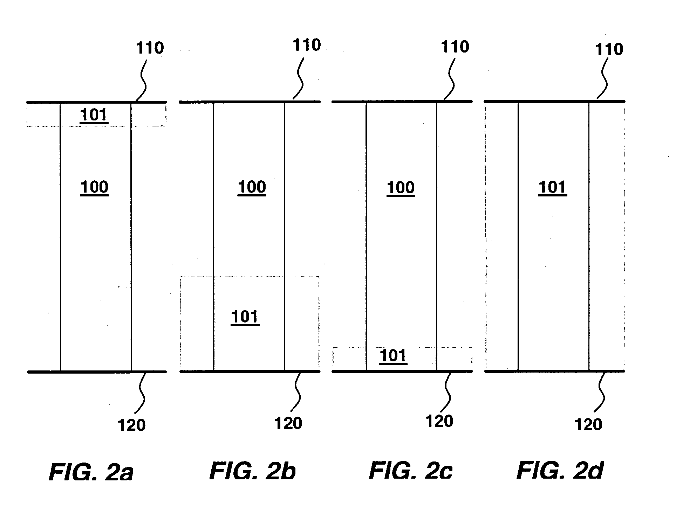

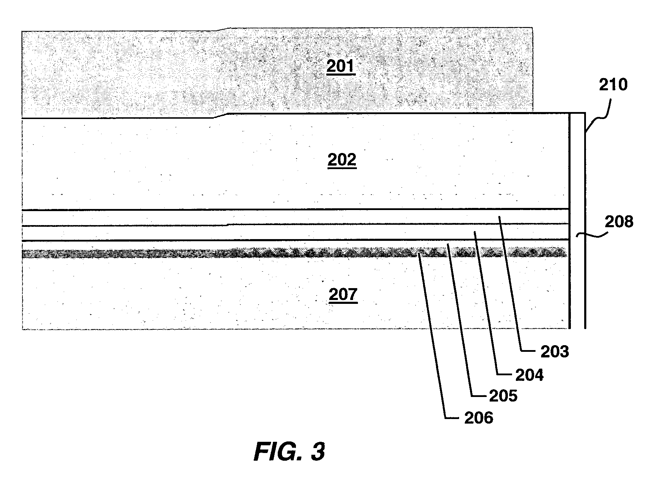

A front facet partial-DFB with low AR coating is a structure where the typical AR coated front facet of a broad area laser (field reflectivity, r, ≈ 10%) is replaced with a short partial-DFB and a very low AR coating (r < 2%). A diagram of what such a structure would look like is shown in Figure 2. In this case the grating is on the n-side of the active region (though it could be on the p-side). An example of front reflectivity vs. wavelength for a front-facet (FF) partial-DFB is shown in Figure 3 for a typical grating strength and overlap. In this example the selectivity is approximately 940±3nm.

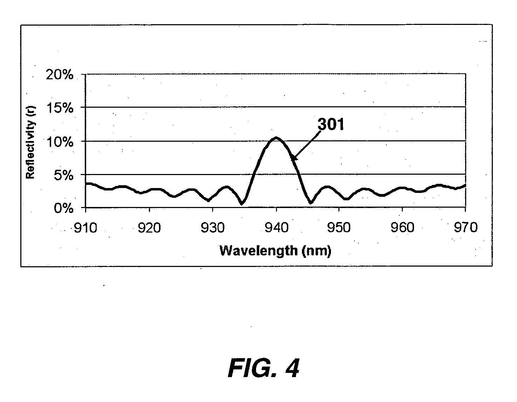

A rear facet partial-DFB with AR coating is a structure with the typical HR coated rear facet of a broad area laser (field reflectivity, r, ≈ 99%) is replaced with a long partial-DFB and a low AR coating (r < 10%). An example of rear reflectivity vs. wavelength for a RF partial-DFB with AR coating is shown in Figure 4 for a typical grating strength and overlap.

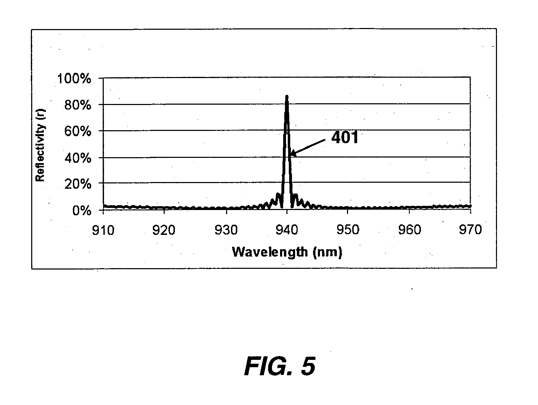

A rear facet partial-DFB with HR coating is a structure with the typical HR coated rear facet of a broad area laser (field reflectivity, r, ≈ 99%) is replaced with a short partial-DFB and a medium HR coating (r ≈ 50%). An example of rear reflectivity vs. wavelength for a RF partial-DFB with HR coating is shown in Figure 5 for a typical grating strength and overlap. The tricky part of this structure is the phase between the partial-DFB and the rear facet can cancel out the wavelength selectivity but it is possible that the multi-mode nature of a broad area laser will enable some wavelength stability.

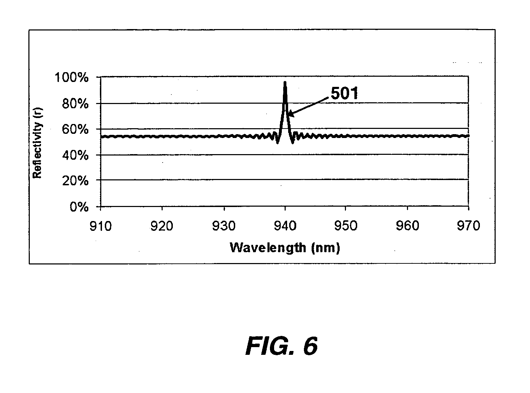

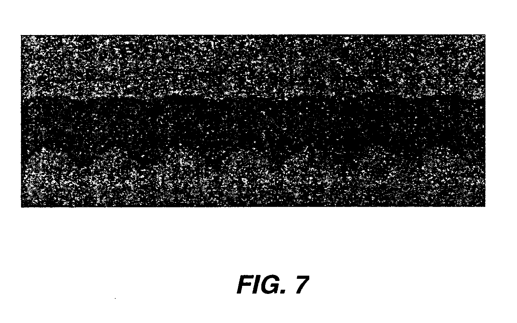

The full DFB grating structure is simply a low coupling grating placed uniformly throughout the laser diode. The front and rear facet will still be AR and HR coated for high efficiency. One difficulty of this structure is achieving wavelength stability with low coupling. Figure 6 shows some examples of how the grating can be placed in partial regions to reduce the total coupling while achieving wavelength stabilization. The second difficulty is the phase matching between the grating and the facets. Figure 7 shows some examples where angling the grating, changing the shape of the grating or varying the pitch (chirped) of the grating could reduce this effect.

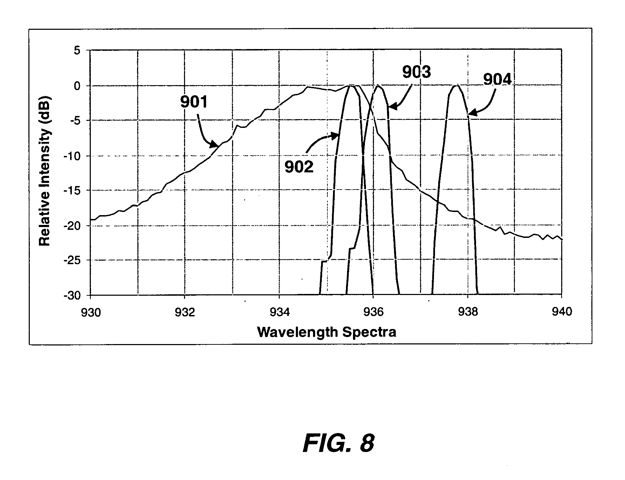

An example of these ideas has been reduced to practice as shown in Figures 8 to 11. Figure 8 is a scanning electron microscope (SEM) picture of a real first-order grating executed in the AIGaAs system used to verify this invention. The invention is not limited to first-order grating, 935nm wavelength or AlGaAs gratings but it used here as a working example of the invention.

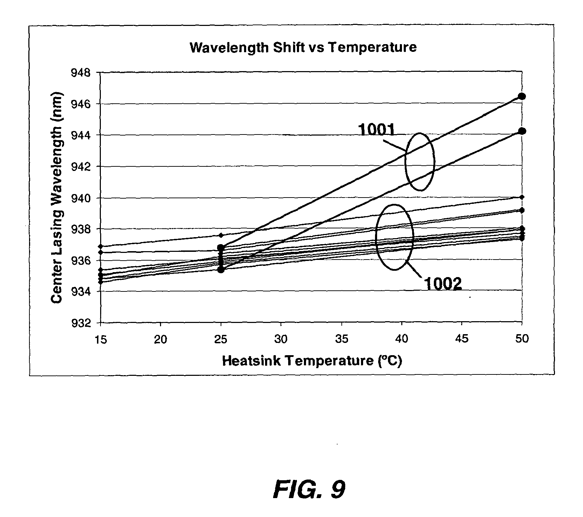

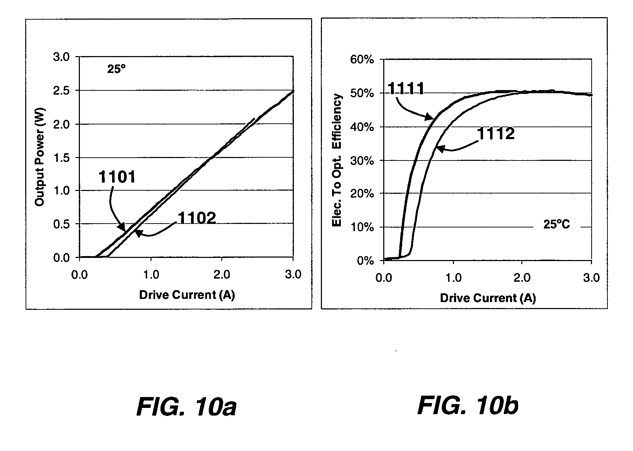

Figure 9 shows spectral data comparing laser diodes with the same dimensions (1.5mm long, 0.1mm aperture) and from the same wafer but one with a partial-DFB grating to stabilize the wavelength and one without a grating. Without the grating the spectral width is greater than 2nm full-width-at-half-maximum (FWHM) which is typical for broad area multi-mode laser diodes. However with the grating the FWHM is reduced to less than 0.5nm. This narrower width could improve the pumping efficiency with a variety of materials. Figure 10 shows the lasing wavelength versus temperature for a number of diodes both with and without a partial-DFB grating. Without the grating, the wavelength shift with temperature exceeds 0.3nm/°C, which corresponds to the shift of active region gain peak. By including the grating, the wavelength shift with temperature is limited to below 0.1nm/°C, which is corresponds to the shift of the AIGaAs grating effective index.

Figure 11 highlights a main benefit of this invention. Because of the low loss grating design the performance of the two lasers is almost identical with similar optical power output characteristics and total efficiency.

The key of this invention is the application of a low loss grating to stabilize wavelength instead of trying to make a single-frequency laser which could introduce excess optical loss and possibly cause undesirable mode hops.

### Brief Description of the Drawings

Exemplary embodiments of the invention will now be described in conjunction with the drawings.

Top views of prior art DFB grating structures are shown in Figures 1a to 1b.

Top views of possible low loss wavelength stabilized grating structures are illustrated in Figure 2a through 2d.

Figure 3 is a diagram of an exemplary cross-section of a partial-DFB structure placed on the output facet side of the laser diode cavity. Depending on the design, the grating can be on the n-side or p-side of the active region at a variety of distances away from the active region and guide layers.

Figure 4 is a plot of the reflectivity vs. wavelength characteristic on the output side of an example front-facet partial-DFB structure.

Figure 5 is a plot of the reflectivity vs. wavelength characteristic on the rear of an example rear facet partial-DFB with AR structure.

Figure 6 is a plot of the reflectivity vs. wavelength on the rear of an example RF partial-DFB structure.

Figure 7 shows a scanning electron microscope view of the cross-section of a first-order 935nm grating executed in the AlGaAs system as a working example. The invention, however, is not limited to AlGaAs, nor gratings of first-order, nor an emission wavelength of 935nm.

Example spectral data of laser diodes with the same dimensions (1.5mm long, 0.1mm aperture) and from the same wafer are compared in Figure 8 to illustrate the wavelength stabilizing effect of a partial-DFB grating.

The lasing wavelength dependence on temperature is plotted in Figure 9 for a number of diodes both with and without a partial-DFB grating.

The drive current characteristics of two laser diodes, one with, and one without a partial-DFB grating are plotted in Figure 10.

### Detailed Description of Preferred Embodiments

In accordance with one aspect of the invention, a broad area semiconductor laser diode has a partial grating inside the resonant cavity in order to restrict the laser oscillation to only a few longitudinal modes as determined by the spectral bandwidth of the partial grating reflectivity. A partial grating is a grating that has a length that is shorter than the laser cavity length. In the case of a segmented grating, the aggregate cavity length of all the segments is less than the cavity length.

The advantage of the invention is that the laser oscillates in a narrow bandwidths and the wavelength drift with temperature is reduced. In addition, the wall plug efficiency of the laser diode with partial grating is substantially the same as a similar laser diode without the partial grating. The disclosure shows several different embodiments for putting the partial grating into the resonant cavity.

The invention disclosure also discloses means for controlling the optical coupling of light between the partial grating and the modes of the laser cavity in order to minimize the losses incurred by placing a partial grating inside the resonant cavity. By this means, the laser efficiency is maintained.

Four distinct grating and facet reflectivity configurations are disclosed, although this list should not be considered as exhaustive: a) a front facet DBR or partial DFB structure with low anti-reflection (AR) coating, b) a rear facet DBR or partial DFB with AR coating, c) a rear facet DBR or partial DFB with high reflectivity (HR) coating and d) a distributed feedback Bragg grating structure throughout the cavity length. The partial DFB section differs from a DBR in that it is electrically pumped.

Top views of these structures are shown schematically in Figures 2a through 2d.

Figure 2a shows the structure of a broad area laser with a short front facet partial DFB or DBR grating 101, where the field reflectivity of the AR coating of the front facet 110 is reduced from typical values of r, ≈ 10%, to very low values, r < 2%. Generally the rear facet 120 is coated to have a high reflectivity. Current is injected into the laser over the broad area 100.

A cross-section of such a structure is illustrated in Figure 3. In this case the grating 206 is on the n-side of the active region 205 (though it could be on the p-side). There are two guide layers doped p-type 203 and n-type 204 sandwiched between the p-type cladding layer 202 and the n-type cladding layer 207 respectively. Electrical current is introduced into the current injected area through a metal electrode 201 which makes contact to the p-type side of the laser. The other electrode makes contact to the n-type side through the substrate (not shown). Only the front facet 210 is shown coated with the AR coating 208.

An example of calculated front facet reflectivity vs. wavelength characteristic 301 is shown in Figure 4 for a partial-DFB whose front-facet (FF) is coated with a two layer AR coating. The grating has a typical strength and a 30 micron length that overlaps with the current injected area. In this example the wavelength selectivity is approximately 940 ±3nm.

Figure 2b shows the structure of a broad area laser with a long rear facet partial DFB or DBR grating 101, where the field reflectivity of the coating of the rear facet 120 is reduced from typical HR values of r,≈ 99%, to lower values more typical of AR coatings, r < 10%. Current is injected into the laser over the broad area 100. The front facet 110 is also AR coated.

An example of calculated front facet reflectivity vs. wavelength characteristic 401 is shown in Figure 5 for a partial-DFB whose front-facet (FF) is coated with an AR coating. The grating has a typical strength and a 300 micron length that overlaps with the current injected area.

Figure 2c shows the structure of a broad area laser with a short rear facet partial DFB or DBR grating 101, where the field reflectivity of the coating of the rear facet 120 is reduced from typical HR values of r, ≈ 99%, to medium values, r ~ 50%. Current is injected into the laser over the broad area 100. The front facet 110 is also AR coated. In this structure, the optical phase of reflections from the partial DFB or DBR grating and the rear facet cannot be controlled in practice. It can affect the wavelength selectivity but with the multi-mode operation of a broad area laser, this can still result in a useful manufacturing yield of wavelength stabilized lasers.

Figure 6 depicts the calculated spectral characteristic 501 of a rear facet partial DFB grating which has a typical strength and a 300 micron length overlapping with the current injected area.

The full DFB grating structure shown in Fig. 1d is simply a grating with low coupling coefficient placed uniformly throughout the cavity length of the broad area laser diode. The front facet 110 is AR coated and the rear facet 120 HR coated for high efficiency. One difficulty with this structure is achieving wavelength stability with low coupling coefficient. Another difficulty is the phase matching between the grating and the facets, which cannot be controlled in manufacture to the desired precision to bring it under control.

An example of how this invention has been reduced to practice as shown in Figures 7 to 10. Figure 7 is a scanning electron microscope (SEM) picture of a real first-order grating executed in the AlGaAs system used to verify this invention. The invention is not limited to first-order grating, 935nm wavelength or AlGaAs gratings but it used here as a working example of the invention.

Figure 8 shows spectral data traces comparing laser diodes having the same dimensions (1.5mm long, 0.1mm wide aperture) and from the same wafer but one with a partial-DFB grating to stabilize the wavelength and one without a grating. Without the grating the laser emission at 25°C has a spectral width 901 greater than 2nm full-width-at-half-maximum (FWHM), which is typical for broad area multi-mode laser diodes. However with the grating, the FWHM is reduced to less than 0.5nm. This narrower width can be used to improve the pumping efficiency for a variety of pumped materials. The stabilizing effect of the grating on the laser emission is demonstrated by the reduced shift in the lasing characteristics 902, 903 and 904 at temperatures of 15°C, 25°C and 50°C respectively. Over this temperature range, the shift is approximately the same as the FWHM of the emission from the laser diode without the grating.

Figure 9 shows the variation of lasing wavelength with temperature for a batch of diodes both with and without a partial-DFB grating. Without the grating, the wavelength shift with temperature exceeds 0.3nm/°C (1001), which corresponds to the shift of active region material gain peak. By including the grating, the wavelength shift with temperature is limited to below 0.1nm/°C (1002), which corresponds to the shift of the AIGaAs grating effective index.

Figures 10a and 10b highlight the main benefits of this invention. Because the grating is designed have low optical loss in the laser cavity, the performance of a laser with the grating is almost identical to the laser without the grating, as evidenced by similar optical power output characteristics and total efficiency. In Fig. 10a, the optical power versus current characteristic at 25°C is compared for the laser with grating 1101 and the laser without grating 1102. The electrical to optical efficiency is plotted in Fig. 10b, also at 25°C, for the laser with grating 1111 and the laser without grating 1112.

It should be clear that the laser with a grating has good linearity demonstrating that multiple modes are still supported, as well as a slightly lower threshold current and slope efficiency because the grating introduces a slightly higher reflectivity than the facet coating on the laser without the grating.

In summary, the key of this invention is the application of a low loss grating to stabilize wavelength instead of trying to achieve single-frequency operation in a laser which could introduce excess optical loss and possibly cause undesirable effects due to mode hops.

## Claims

1. A semiconductor pump laser comprising:
a semiconductor chip having a first facet at one end thereof and a second facet at the opposite end thereof;
a optical waveguide between the first facet and the second facet, wherein the optical waveguide and the first and second facets form an optical cavity capable of supporting lasing modes, wherein the optical waveguide includes an active layer therein;
a grating within the waveguide, wherein the grating has a grating length; wherein the grating provides distributed feedback for a plurality of adjacent lasing modes; and wherein the grating is coupled to the active layer at a coupling factor;
**characterized in that**
the grating length is less than the cavity length;
the cavity length is between about 800 micron and 3000 micron; and
the grating has a coupling factor - cavity length product of 0.2 or less.

2. The semiconductor pump laser as defined in claim 1 wherein the grating is divided into more than one non-contiguous segment.

3. The semiconductor pump laser as defined in claim 1 wherein the grating is a first order grating.

4. The semiconductor pump laser as defined in claim 1 wherein the cavity is made of compound semiconductor.

5. The semiconductor pump laser as defined in claim 4 wherein the compound semiconductor is a combination of one or more of aluminum, gallium, and arsenic.

6. The semiconductor pump laser as defined in claim 5 wherein the emission wavelength is between about 790nm and 1000nm.
